# EUROPÄISCHE PATENTANMELDUNG

(11) **EP 1 806 840 A1**
(43) Veröffentlichungstag der Anmeldung: **11.07.2007**
(21) Anmeldenummer: 06000228.4
(22) Anmeldetag: 05.01.2006
(51) Int. Cl.: H03G 3/32, H04M 1/60

(54) **Adaptive Verstärkung zur Kontrolle der Sprechlautstärke**

(71) Anmelder: Siemens Schweiz AG, 8047 Zürich (CH)
(72) Erfinder: Wenger, Bruno, 8804 Au (CH)
(74) Vertreter: Kley, Hansjörg

(57) **Zusammenfassung**

Innerhalb von Grossraumbüros besteht praktisch immer das Problem, dass gewisse Personen beim Telefonieren unnötig sehr laut sprechen und damit ihre KollegenInnen erheblich bei der Arbeit stören. Um diesem lästigen Problem abzuhelfen, wird ein Verfahren und eine Schaltungsanordnung vorgeschlagen, bei der die eigene Sprache (20, 4) mit einem Verstärker (16) progressiv in den Lautsprecher (10) eingefügt wird, so dass jede einigermassen nicht hörgeschädigte Person ihre Sprechlautstärke auf ein der Umgebung erträgliches Mass zurücknimmt.

## Beschreibung

Die vorliegende Erfindung betrifft ein Verfahren zur Kontrolle der Sprechlautstärke einer Person gemäss dem Oberbegriff des Patentanspruches 1 und eine Schaltungsanordnung zur Kontrolle der Sprechlautstärke gemäss dem Oberbegriff des Patentanspruches 6.

Innerhalb von Grossraumbüros besteht praktisch immer das Problem, dass gewisse Personen beim Telefonieren sehr laut und auch lange sprechen und damit ihre Kollegen und Kolleginnen erheblich bei der Arbeit beeinträchtigen.

Heutzutage wird in zunehmendem Masse in Grossraumbüros gearbeitet, womit dieses Problem immer mehr auftritt. Es nützt wenig, die betreffenden Personen auf ihre laute Sprachgewohnheit aufmerksam zu machen, da sie nicht ständig daran denken und trotz guten Bemühungen immer wieder in ihr gewohntes Lautstärkemuster zurück fallen. Auch Stellwände und dergleichen bringen nur wenig wirkung, da auch die Akustik der Räumlichkeiten normalerweise nicht auf eine optimale Schallabsorption ausgelegt ist.

Aus der DE 3627002 A1 [1] ist ein Verfahren und eine Schaltungsanordnung zur akustischen Kompensation des Umgebungsgeräusches bekannt, bei denen der Umgebungslärm mit einem Referenzmikrofon gemessen durch ein entsprechendes invertiertes Signal am Ende des Hörwegs liegenden Lautsprechers dem Nutzsignal überlagert wird. Diese Lösung eignet sich nur aus Sicht des anderen Teilnehmers, dadurch wird eine Person jedoch in keiner Weise gehindert, laut bzw. zu laut zu sprechen.

Auch die in der Schrift EP 0 989 541 A1 [2] offenbarte Lösung, wonach in einer Telefonkabine eine Geräuschminderung durch eine gegenphasige Einspeisung des Umgebungslärm kompensiert wird, löst das vorgenannte Problem mit dem unnötigen Lautsprechen einer Person nicht, da diese Lösung in einem Grossräumbüro mit vielen dezentralen Lärmquellen wie Maschinengeräusche oder andere unnötig laut sprechende Personen nicht anwendbar ist.

Die einzige praktikable Lösung ist eine technische Massnahme, die jederzeit dafür sorgt, dass man am Telefon freiwillig leise spricht.

Der vorliegenden Erfindung liegt daher die Aufgabe zugrunde, ein Verfahren und eine Schaltungsanordnung anzugeben, die eine am Telefon sprechende Person unabhängig vom Umgebungslärm zwingt, die Sprechlautstärke auf ein normales und für die Umgebung erträgliches Mass zurückzunehmen.

Diese Aufgabe wird für ein Verfahren der eingangs genannten Art durch die im Patentanspruch 1 angegebenen Merkmale und für die Schaltungsanordnung durch die im Patentanspruch 6 angegebenen Merkmal gelöst.

Durch das erfindungsgemässe Verfahren, wonach
«das vom Mikrofon entstammende Signal in einem Verstärker progressiv verstärkt und als Echosignal dem Lautsprecher zugeführt wird»;
wird jede einigermassen nicht hörgeschädigte oder nicht verhaltensgestörte Person ihre Sprechlautstärke auf ein der Umgebung erträgliches Mass zurücknehmen, da durch den Effekt, dass lautes Sprechen im Ohr überproportional im Hörer wiedergegeben wird. Überproportional wird hier «progressiv» oder auch etwas ungenau «adaptiv» genannt.

Der vorliegende Ansatz geht davon aus, dass der Mensch seine Sprechlautstärke in einem grossen Masse darüber reguliert, wie laut er sich selber sprechen hört. Zusätzlich spielen natürlich auch emotionale Faktoren eine Rolle, etwa wenn jemand bewusst schreien will. Bei einem normalen, emotionslosen Telefongespräch wird die Lautstärke immer etwa gleich sein. Psychologisch begründet kann das unbewusste Gefühl sein, etwas lauter sprechen zu müssen, weil der Andere am fernen Ende der Leitung schliesslich sehr weit weg ist, Rational gesehen ist dies natürlich ein völliger Unfug im Zeitalter der digitalen Telefonie.

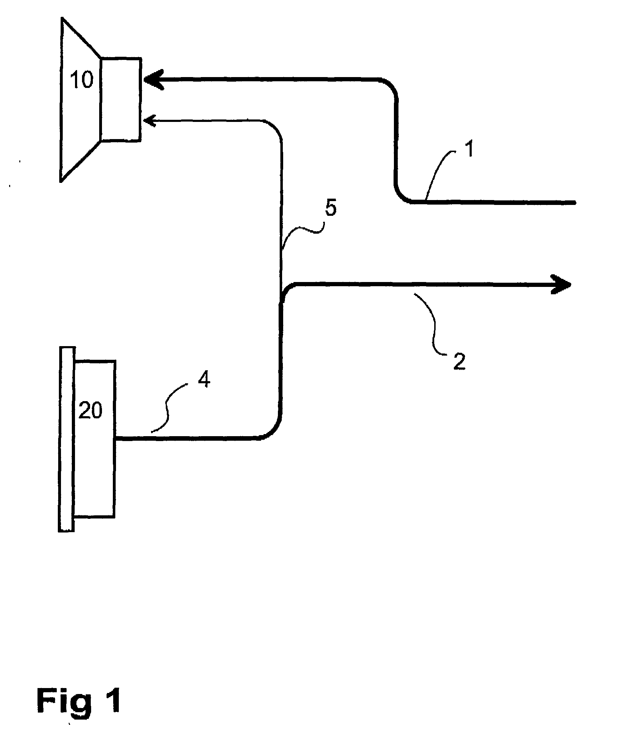

Jeder Telefonapparat hat einen so genannten Echopfad 5 oder auch Echosignal 5 genannt: Man hört im Hörer 10 mit unterdrückter Lautstärke mit, was man gerade ins Mikrofon 20 spricht. Dies ist in prinzipieller Art in Figur 1 dargestellt. Ohne diese Massnahme hätte man den Eindruck, dass der Telefonapparat gar nicht funktioniert. Wenn nun die Verstärkung dieses Echopfades 5 lautstärkeabhängig progressiv ausgelegt wird, und zwar z.B. sogar exponentiell, wird niemand mehr laut ins Mikrofon sprechen, weil er sich dann übermässig laut im Hörer 10 hört. Gleichzeitig kann das abgehende Sprachsignal 2 entsprechend der nun reduzierten Sprech-lautstärke etwas verstärkt werden, damit gegenüber dem Teilnehmer auf der anderen Seite die Verständlichkeit trotzdem gewährleistet ist, auch wenn nun leise oder mit einem vernünftigen Pegel gesprochen wird.

Weitere vorteilhafte Ausgestaltungen der Erfindung sind in weiteren Ansprüchen angegeben.

Die Erfindung wird nachfolgend anhand der Zeichnung beispielsweise näher erläutert. Dabei zeigen:
Figur 1 Schaltungsanordnung nach dem Stand der Technik;
Figur 2 schaltungsanordnung in einer bevorzugten Ausführung gemäss der vorliegenden Erfindung.

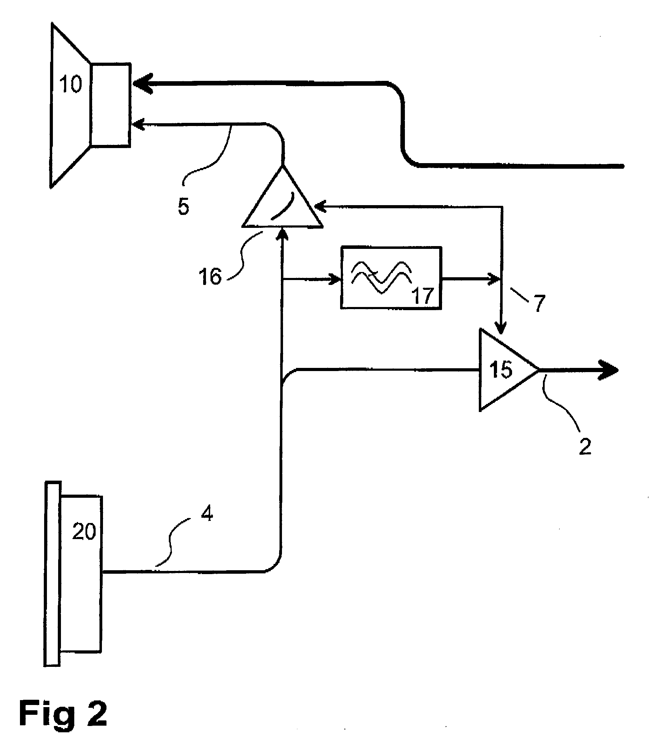

Eine bevorzugte Ausführungsform der vorliegenden Erfindung wird anhand der Figur 2 erläutert. Die einzelnen Komponenten Mittelwertstufe 17, Verstärker 16 und Lautstärkeregelung haben folgende Funktionen:
Mittelwertbildung on einer Mittelwertstufe 17
Mittels eines Filters wird die mittlere Lautstärke des Sprechsignals berechnet. Die Mittelung muss über eine genügend lange, dem natürlichen Sprechen angepasste Zeit erfolgen, z.B. 10 sec. Wenn nicht gesprochen wird, soll der letzte Mittelwert beibehalten werden.

### Verstärker 16 im Echopfad 5

Der Mittelwert steuert die Verstärkung des Echosignals 5, und zwar progressiv. Damit hört sich die Person umso intensiver, je lauter sie spricht. Progressiv heisst: die vom Pegel des Signals 4 abhängige Verstärkungen ist exponentiell oder überproportional. Dies bedeutet z.B. einen Verstärkungsfaktor, der linear mit dem Pegel des dem Mikrofon entstammenden Sprachsignals ansteigt. Anstelle einer exponentiellen Verstärkung des Echosignals kann auch eine Schwelle gesetzt werden. Überschreitet der Mittelwert diese Schwelle, wird im Hörer ein akustisches Signal eingeblendet, das den Telefonierenden darauf aufmerksam macht, dass er zu laut spricht.

### Lautstärkeregelung 15

Weil dank der neuen Anordnung tendenziell eher zu leise gesprochen wird, muss dies mittels einer Verstärkung in einer Lautstärkeregelung 15 in Richtung des anderen Teilnehmers kompensiert werden. Bei kleiner Sprechlautstärke wird das Sendesignal 2 etwas verstärkt, so dass es im Mittel wiederum etwa eine normale, konstante Lautstärke hat.

Die beschriebenen Funktionen können auf verschiedene Arten aktiviert werden. Entweder am Telefonapparat (auch «Sprachendgerät» genannt) selber, z.B. mittels einer Taste oder auch ferngesteuert über die Telefonleitung. Bei einer ferngesteuerten Aktivierung kann darüber die Möglichkeit angeboten werden, diese lokal am Telefonapparat wieder zu deaktivieren.

Moderne Telefonapparate verfügen über eine komplett digitale Signalverarbeitung, die auch den im Stand der Technik bereits enthaltenen Echopfad 5 sowie eine allfällige Verstärkung 15 des Sprachsignals 4 umfasst. Dies hat folgend Vorteile:
a) Die beschriebene Massnahme kann demnach durch eine reine SW-Anpassung des Telefonapparats einfach und kostengünstig umgesetzt werden.
b) Auch nachträgliche Erweiterungen sind durch einen reinen SW-Update möglich.
c) Das Feature «kontrollierte Sprechlautstärke» kann wahlweise ein- und ausgeschaltet werden.

Die in dieser Ausführungsform beschriebenen Funktionen können frei kombiniert werden, z.B. ist die Lautstärke-Regelung 15 nicht unbedingt erforderlich oder falls eine Mittelwertstufe 17 vorgesehen ist, kann deren Ausgang wahlweise dem Verstärker 16 und/oder der Lautstärke-Regelung 15 zugeführt werden.

### Liste der verwendeten Bezugszeichen, Glossar

- 1: Empfangssignal
- 2: sendesignal
- 4: Signal vom Lautsprecher; Sprechsignal
- 5: Echosignal; Echopfad
- 7: Mittelwert
- 10: Lautsprecher
- 15: Lautstärke-Regelung
- 16: Verstärker, Exponentialverstärker
- 17: Mittelwertstufe
- 20: Mikrofon

### Liste der verwendeten Akronyme

- SW: Software

### Literaturliste

[1] DE 3627002 A1
   «verfahren und Schalungsanordnung zur akustischen Kompensation des Umgebungsgeräusches bei Kopfhörerempfang»
   Philips Patentverwaltung GmbH, 2000 Hamburg
[2] EP 0 989 542 A1
   «verfahren und Vorrichtung zur aktiven Geräuschverminderung in offenen Telefonzellen»
   Deutsche Telekom AG, 5113 Bonn

## Patentansprüche

1. Verfahren zur Kontrolle der Sprechlautstärke einer Person an einem Sprachendgerät enthaltend Mikrofon (20) und Lautsprecher (10); bei dem vom Mikrofon (20) zum Lautsprecher (10) ein Echosignal (5) geführt wird;
**dadurch gekennzeichnet, dass**
das vom Mikrofon (20) entstammende Signal (4) in einem Verstärker (16) progressiv verstärkt und als Echosignal (5) dem Lautsprecher (10) zugeführt wird.

2. Verfahren nach Anspruch 1,
**dadurch gekennzeichnet, dass**
der Verstärker (16) einen Verstärkungsfaktor aufweist, der linear mit dem Pegel des dem Mikrofon (5) entstammenden Signals (4) anwächst.

3. Verfahren nach Anspruch 1,
**dadurch gekennzeichnet, dass**
der Verstärker (16) einen Verstärkungsfaktor aufweist, der exponentiell mit dem Pegel des dem Mikrofon (20) Signals (4) anwächst.

4. Verfahren nach einem der Ansprüche 1 bis 3,
**dadurch gekennzeichnet, dass**
das dem Mikrofon (20) entstammende Signal (4) einer Mittelwertstufe (17) zur Bildung eines Mittelwertes (7) zugeführt wird, und dass der Mittelwert (7) dazu benutzt wird, um das Sendesignal (2) in Richtung des anderen Teilnehmers in einer Lautstärke-Regelung (15) zu verstärken.

5. Verfahren nach Anspruch 4,
**dadurch gekennzeichnet, dass**
dass der über eine definierte Zeitspanne gebildete Mittelwert (7) dem Verstärker (16) zugeführt wird, um eine über die Zeitspanne betrachtet gleichmässige Verstärkung herbeizuführen.

6. Schaltungsanordnung zur Kontrolle der Sprechlautstärke einer Person an einem Sprachendgerät zur Durchführung des Verfahrens nach einem der Ansprüche 1 bis 5, welche Schaltungsanordnung aufweist:
Mikrofon (20) und Lautsprecher (10); wobei das Mikrofon (20) mit dem Lautsprecher (10) verbunden ist, um ein Echosignal (5) dem Lautsprecher zuzuführen,
**dadurch gekennzeichnet, dass**
in die Verbindung (5) Mikrofon (20) mit dem Lautsprecher (10) ein Verstärker (16) eingefügt ist, der ein vom Mikrofon entstammendes Signal (4) progressiv verstärkt und als Echosignal (5) dem Lautsprecher (10) zugeführt.

7. schaltungsanordnung nach Anspruch 6,
**dadurch gekennzeichnet, dass**
der Verstärker (16) einen Verstärkungsfaktor aufweist, der linear mit dem Pegel des dem Mikrofon (5) entstammenden Signals (4) anwächst.

8. Schaltungsanordnung nach Anspruch 6,
**dadurch gekennzeichnet, dass**
der Verstärker (16) einen Verstärkungsfaktor aufweist, der exponentiell mit dem Pegel des dem Mikrofon (20) Signals (4) anwächst.

9. Schaltungsanordnung nach einem der Ansprüche 6 bis 8,
**dadurch gekennzeichnet, dass**
das Mikrofon (20) mit einer Mittelwertstufe (17) verbunden ist und die Mittelwertstufe (17) ihrerseits mit dem Verstärker (16) verbunden ist, wobei der von der Mittelwertstufe (17) gebildete Mittelwert (7) dazu benutzt wird, um das Sendesignal (2) in Richtung des anderen Teilnehmers in einer Lautstärke-Regelung (15) zu verstärken.

10. Schaltungsaxlordnung nach Anspruch 9;
**dadurch gekennzeichnet, dass**
dass der über eine definierte zeitspanne gebildete Mittelwert (7) dem Verstärker (16) zugeführt wird, um eine über die zeitspanne betrachtet gleichmässige Verstärkung herbeizuführen.
